# EUROPÄISCHE PATENTSCHRIFT

(11) **EP 1 997 116 B1**
(45) Veröffentlichungstag und Bekanntmachung des Hinweises auf die Patenterteilung: **29.07.2009**
(21) Anmeldenummer: 07723069.6
(22) Anmeldetag: 07.03.2007
(51) Int. Cl.: H01F 6/04

(54) **KRYOSTAT MIT EINEM MAGNETSPULENSYSTEM, DAS EINE LTS- UND EINE IM VAKUUMTEIL ANGEORDNETE HTS-SEKTION UMFASST**
CRYOSTAT HAVING A MAGNET COIL SYSTEM, WHICH COMPRISES AN LTS SECTION AND AN HTS SECTION, WHICH IS ARRANGED IN THE VACUUM PART
CRYOSTAT MUNI D'UN SYSTÈME DE BOBINES MAGNÉTIQUES QUI COMPREND UNE SECTION LTS ET UNE SECTION HTS DISPOSÉE DANS LA PARTIE SOUS VIDE

(30) Priorität: 18.03.2006 DE 102006012509
(43) Veröffentlichungstag der Anmeldung: 03.12.2008
(73) Patentinhaber: Bruker BioSpin GmbH, 76287 Rheinstetten (DE)
(72) Erfinder: KASTEN, Arne, 76139 Karlsruhe (DE)
(74) Vertreter: Kohler Schmid Möbus
(86) Internationale Anmeldenummer: PCT/EP2007/001924
(87) Internationale Veröffentlichungsnummer: WO 2007/107238

(56) Entgegenhaltungen:
- EP-A1- 0 780 698
- EP-A2- 0 905 436
- DE-A1-0102004 007 34

## Beschreibung

Die Erfindung betrifft einen Kryostaten, mit einem supraleitfähige Leiter umfassenden Magnetspulensystem zur Erzeugung eines Magnetfelds B₀ in einem Messvolumen, mit mehreren, radial ineinander geschachtelt angeordneten, elektrisch in Serie geschalteten, solenoidförmigen Spulensektionen, von denen mindesten eine LTS-Sektion einen konventionellen Tieftemperatursupraleiter (LTS) und mindestens eine HTS-Sektion einen Hochtemperatursupraleiter (HTS) umfasst, wobei sich die LTS-Sektion mit flüssigem Helium in einem Heliumtank des Kryostaten bei einer Helium-Temperatur T_{L} befindet.

Ein solcher Kryostat ist beispielsweise bekannt geworden aus der DE 10 2004 007 340 A1.

Zum Beispiel für Kernspinresonanz-Apparaturen, insbesondere Spektrometer, werden sehr starke, homogene und stabile Magnetfelder benötigt. Je stärker das Magnetfeld, desto besser ist das Signal-zu-Rausch-Verhältnis und die spektrale Auflösung der NMR-Messung.

Zur Erzeugung starker Magnetfelder werden supraleitende Magnetspulensysteme eingesetzt. Weit verbreitet sind Magnetspulensysteme mit solenoidförmigen Spulensektionen, die ineinander geschachtelt sind und in Serie betrieben werden. Supraleiter können elektrischen Strom verlustfrei tragen. Die Supraleitung stellt sich unterhalb einer materialabhängigen Sprungtemperatur ein. Als Supraleitermaterial werden typischerweise konventionelle Tieftemperatur-Supraleiter (LTS) eingesetzt. Diese Metatltegie-rungen wie beispielsweise NbTi und Nb₃Sn sind verhältnismäßig leicht zu verarbeiten und zuverlässig in der Anwendung. Der Leiter einer LTS-Spulensektion besteht in der Regel aus einer gut normalleitenden metallischen Matrix (Kupfer), in der sich supraleitende Filamente befinden, die im Normalbetrieb vollständig den Strom übernehmen. Im Fall von NbTi sind das üblicherweise einige zehn bis hundert, im Fall von Nb₃Sn können es mehr als hunderttausend sein. Tatsächlich ist der innere Aufbau der Leiter noch etwas komplexer, was aber im vorliegenden Zusammenhang keine Rolle spielt.

Um die Spulensektionen unter die Sprungtemperatur abzukühlen, werden die Spulensektionen mit flüssigem Helium in einem Kryostaten gekühlt. Die supraleitenden Spulensektionen tauchen dabei i.a. zumindest teilweise in flüssiges Helium ein.

Um die erreichbare Magnetfeldstärke in einem Magnetspulensystem weiter zu steigern, ist es wünschenswert, auch Hochtemperatur-Supraleiter (HTS) einzusetzen. Bei gleicher Temperatur können Leiter, die HTS enthalten, sehr viel mehr Strom tragen und höhere Magnetfeldstärken erreichen als solche mit LTS. HTS-Material bietet sich somit vor allem als Material für die innersten Spulensektionen eines Magnetspulensystems an.

HTS oder auch keramische Supraleiter gibt es derzeit vor allem als Wismut-Leiter mit HTS-Filamenten in einer silberhaltigen Matrix. Die Leiter haben vorwiegend die Form von Bändchen.

Spulensektionen aus HTS vor allem in unterkühltem Helium haben sich bisher allerdings als kurzlebig und unzuverlässig erwiesen. Eine Untersuchung von ausgefallenen HTS-Sektionen hat ergeben, dass das HTS-Material aufplatzt und die Stromtragfähigkeit des HTS-Leiters damit zerstört wird. Dieser an sich auch in anderen Zusammenhängen bekannte Effekt wird gelegentlich als "ballooning" bezeichnet.

### Aufgabe der Erfindung

Demnach ist es die Aufgabe der vorliegenden Erfindung, einen Kryostaten bereitzustellen, in dem eine HTS-Spulensektion langfristig und zuverlässig eingesetzt werden kann, und insbesondere kein "ballooning" auftritt.

### Kurze Beschreibung der Erfindung

Diese Aufgabe wird gelöst durch einen Kryostaten der eingangs vorgestellten Art, der dadurch gekennzeichnet ist, dass die HTS-Sektion radial innerhalb der LTS-Sektion in einem Vakuumteil des Kryostaten angeordnet ist und von der LTS-Sektion durch die der Raumtemperaturbohrung zugewandte Wand des Heliumtanks getrennt ist.

Der vorliegenden Erfindung liegt die Erkenntnis zugrunde, dass das "ballooning" durch Helium verursacht wird, das im Inneren des HTS-Materials expandiert oder verdampft. Bekanntermaßen verflüssigt sich Helium bei 1 bar Druck unterhalb von ca. 4,2 K. HTS-Material ist keramisch und weist daher typischerweise eine gewisse Porosität auf. Das flüssige Helium kann durch die Poren in das Innere des HTS eindringen. Insbesondere im superflüssigen Zustand des Heliums, der unterhalb der λ-Punkt-Temperatur von ca. 2,2 K gegeben ist, kann das Helium auch durch kleinste Spalte dringen. Im Falle einer späteren Erwärmung über den Siedepunkt des Heliums hinaus nimmt das Helium beim Verdampfen stark an Volumen zu. Erfolgt die Erwärmung zu rasch, so kann das verdampfende Helium nicht rechtzeitig aus den Poren entweichen, und ein erheblicher Druck baut sich in den Poren des HTS auf. Da HTS ein keramisches und damit sprödes Material ist, kann der HTS schließlich von diesem Druck gesprengt werden.

Dies alles kann durch den erfindungsgemäßen Kryostaten verhindert werden. Die HTS-Sektion oder die HTS-Sektionen des Magnetspulensystems, und damit alles HTS-Material, ist im Vakuumteil des Kryostaten zwischen der Innenwand des Heliumtanks und der Raumtemperaturbohrung angeordnet. Im Vakuumteil ist selbstversändlich keinerlei flüssiges Helium vorhanden Der Vakuumteil eines NMR-Kryostaten ist in der Regel einstückig. Die HTS-Sektion liegt beispielsweise mit ihrem äußeren, kreiszylinderförmigen Umfang an der ebenfalls kreiszylinderförmigen Innenwand des Heliumtanks an und ist durch diese kraftschlüssig mit der radial innersten LTS-Sektion verbunden, die ggf. über kleine Distanzstücke von der Heliumseite her an dieser Wand anliegt. Da das HTS-Material der HTS-Sektion(en) im Vakuum nicht in Kontakt mit flüssigem Helium kommt, kann es naturgemäß auch nie zu einer Verdampfung von eingedrungenem flüssigen Helium im Inneren des HTS-Materials kommen. Dadurch ist ein "ballooning" des HTS ausgeschlossen.

Die Kühlleistung für die HTS-Sektion kann über thermische Kontakte, beispielsweise aus Kupfer, von der Heliumtankwand zur HTS-Sektion übertragen werden. Dabei darf die Betriebstemperatur der HTS-Sektion durchaus etwas höher sein als die der LTS-Sektionen im Heliumtank, da um oder unter 4 K der kritische Strom des HTS-Leiters nur noch sehr wenig von der Temperatur abhängt, im Gegensatz zur Situation bei den LTS-Sektionen. Dies gilt insbesondere, wenn das Helium im Tank unterkühlt bei etwa 2 K vorliegt.

Bevorzugt ist eine Ausführungsform des erfindungsgemäßen Kryostaten, bei der die Temperatur des flüssigen Heliums T_{L} < 4 K, vorzugsweise < 2,5 K, insbesondere < 2,2 K ist. Bei diesen niedrigen Temperaturen ist die Gefahr eines Balloonings ohne die erfindungsgemäßen Maßnahmen besonders groß, so dass die Vorteile der Erfindung besonders zur Geltung kommen. Da die kritischen Stromdichten der Leiter der LTS-Sektionen mit sinkender Temperatur zunehmen, gestatten die niedrigen Temperaturen höhere Magnetfeldstärken B₀ und/oder kompaktere LTS-Sektionen.

Eine bevorzugte Ausführungsform des erfindungsgemäßen Kryostaten sieht vor, dass auch supraleitende Zuleitungen zur mindestens einen HTS-Sektion im Vakuumteil verlaufen, und zwar mindestens soweit die Zuleitungen HTS enthalten. Dadurch wird alles HTS-Material einschließlich der Joints vor flüssigem Helium geschützt. Ab diesen Joints vertäuft dann in der Regel jeweils ein Leiter aus konventionellem Supraleitermaterial, z.B. ein NbTi-Multifilamentdraht, zu einer vakuumdichten Durchführung in den Heliumtank, vorzugsweise in einem Bereich, in dem üblicherweise im Heliumtank kein flüssiges Helium vorliegt, zumindest kein superflüssiges. Der supraleitende Leiter wird durch diese Durchführung durchgeführt, so dass der volle Magnetstrom verlustfrei von der HTS-Sektion zu den LTS-Sektionen und zurück gelangen kann. Ein supraleitender Schalter für den verlustfreien Dauerstrombetrieb (persistent mode) befindet sich in der Regel im Heliumtank, bei vertikal angeordneter Magnetspule oberhalb der LTS-Sektionen. Im Fall von zwei gekoppelten Heliumtanks bei etwa 2 K (mit LTS-Sektionen) und etwa 4 K führen die Durchführungen bevorzugt vom Vakuum in den 4K-Tank.

Eine weitere bevorzugte Ausführungsform sieht vor, dass die LTS-Sektion mit der HTS-Sektion mechanisch starr verbunden ist, insbesondere durch bzw. über die Wand des Heliumtanks. Dies macht das Magnetspulensystem mechanisch und damit auch die Magnetfeldstärke B₀ besonders stabil.

Ebenfalls bevorzugt ist eine Ausführungsform, bei der die HTS-Sektion thermisch an die Wand des Heliumtanks angekoppelt ist. Dadurch wird die HTS-Sektion mit geringem apparativen Aufwand ausreichend gekühlt.

Vorteilhaft ist weiterhin eine Ausführungsform, gemäß der sich zwischen HTS-Sektion und Raumtemperaturbohrung mindestens ein Strahlungsschild befindet, der vorzugsweise an einen Heliumtank angekoppelt ist und dadurch eine Temperatur von etwa 4.2 K oder darunter annimmt. Der Strahlungsschild reduziert einen Wärmeeintrag durch Strahlung von der Raumtemperaturbohrung in die HTS-Sektion.

Bei Bedarf können auch Maßnahmen getroffen sein, die im Vakuumteil verlaufenden Zuleitungen zur HTS-Sektion thermisch abzuschirmen, etwa dadurch, dass sie innerhalb des Strahlungsschildes verlaufen oder sie über Wärmeleitung zu kühlen, z.B. durch parallel verlaufende, thermisch gut leitende Leitungen. Dadurch kann ein Quenchen dieser Leitungen inklusive etwaiger Joints vermieden werden.

Bei einer vorteilhaften Ausführungsform sind in dem Vakuumteil Sorptionsmittel für Helium angeordnet, insbesondere Aktivkohle. Dies macht langfristig den Einsatz externer und/oder fördernder Pumpen entbehrlich.

Eine bevorzugte Ausführungsform sieht vor, dass das im Messvolumen durch das Magnetspulensystem erzeugte Magnetfeld B₀ größer als 20 T, insbesondere größer als 23 T ist. Diese starken Magnetfelder sind mittels HTS-Sektion und dem erfindungsgemäßen Kryostaten gut erreichbar. Im Gegensatz dazu wird mit konventionellen Magnetsystemen, die nur auf LTS-Sektionen basieren, bei diesen Feldstärken schon die theoretische Grenze nahezu erreicht, und die kritische Stromdichte strebt gegen null.

Bevorzugt ist weiterhin eine Ausführungsform; bei der die Spulensektionen des Magnetspulensystems im Betrieb supraleitend kurzgeschlossen werden können. Dadurch wird ein zeitlich besonders stabiles Magnetfeld B₀ erreicht.

Ebenfalls bevorzugt ist eine Ausführungsform, die dadurch gekennzeichnet ist, dass das Magnetspulensystem bezüglich der Homogenität des Magnetfelds B₀ im Messvolumen und der zeitlichen Stabilität von B₀ die Anforderungen der hochauflösenden NMR-Spektroskopie erfüllt.

Bevorzugt ist schließlich noch eine Ausführungsform, bei der der Kryostat einen weiteren Heliumtank mit einer Temperatur des darin enthaltenen flüssigen Heliums von etwa 4,2 K aufweist, der mit dem (ersten) Heliumtank verbunden ist. Das flüssige Helium im (ersten) Heliumtank hat eine Temperatur T_{L} < 4K. Durch die Verwendung zweier Heliumtanks können einerseits die LTS-Sektionen bei tieferer Temperatur betrieben werden, was ihre Stromtragfähigkeit erhöht und andererseits das Helium bei etwa Normaldruck aus dem Kryostaten abdampfen und auch bei diesem Druck nachgefüllt werden, was der Wirkungsgrad der Kühlung und die Betriebssicherheit erhöht.

Eine vorteilhafte Weiterbildung dieser Ausführungsform sieht vor, dass die Serienschaltung zwischen der LTS-Sektion im Heliumtank und der HTS-Sektion im Vakuumteil über den weiteren Heliumtank verläuft. Die Durchführung von supraleitenden Zuleitungen in den Vakuumteil erfolgt über den weiteren Heliumtank. Insbesondere wenn im (ersten) Heliumtank superflüssiges Helium vorhanden ist, erleichtert dies die sichere Abdichtung der Stromdurchführung.

Bei einer bevorzugten Weiterbildung ist der weitere Heliumtank über dem Heliumtank um eine gemeinsame, vertikale Raumtemperaturbohrung angeordnet. Bei diesem Aufbau können die beiden Tanks durch eine Vakuumbarriere getrennt und über eine enge, z.B. spaltförmige Verbindung gekoppelt werden. Der obere Tank kann sich etwa auf Normaldruck oder leicht darüber befinden, so dass insgesamt das Nachfüllen von Helium leichter und sicherer erfolgen kann.

Eine Weiterentwicklung davon sieht vor, dass die der Raumtemperaturbohrung zugewandte Wand des weiteren Heliumtanks radial von der Raumtemperaturbohrung gleich weit beabstandet ist wie die der Raumtemperaturbohrung zugewandte Wand des Heliumtanks. Dies gestattet insbesondere die einfache Anbringung einer horizontal verlaufenden Durchführung am weiteren Heliumtank in einer Höhe, bei der normalerweise kein flüssiges Helium im weiteren Heliumtank mehr steht.
Dies macht wiederum die Abdichtung der Durchführung sicherer. Auch ergibt sich eine topologisch einheitliche innere Bohrung, soweit sie durch die Heliumtanks begrenzt wird. Dies verbessert die Zugänglichkeit und Nutzung der Bohrung.

Alternativ kann jedoch auch die der Raumtemperaturbohrung zugewandte Wand des weiteren Heliumtanks radial von der Raumtemperaturbohrung weniger weit beabstandet sein als die der Raumtemperaturbohrung zugewandte, Wand des Heliumtanks, was es auf einfache Weise erlaubt, die Stromdurchführung in der ebenen Bodenplatte des weiteren (oberen) Heliumtanks anzubringen. Das Volumen des weiteren Heliumtanks kann dadurch größer sein, was die Heliumstandzeit erhöht. Bevorzugt ist auch, dass die der Raumtemperaturbohrung zugewandte Wand des weiteren Heliumtanks mit der Innenbohrung der HTS-Sektion fluchtet.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Zeichnung

Die Erfindung ist in der Zeichnung dargestellt und wird anhand von Ausführungsbeispielen näher erläutert. Es zeigen:

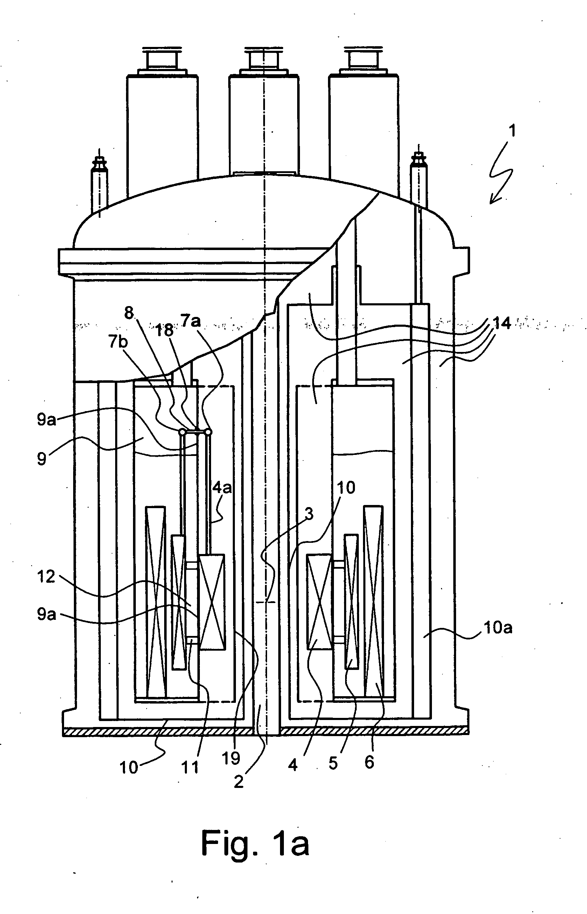

- Fig. 1a: eine erste Ausführungsform eines erfindungsgemäßen Kryostaten mit HTS-Sektion im Vakuum und zugehörige Joints und Durchführungen, in schematischer Darstellung;
- Fig. 1 b: eine zweite Ausführungsform eines erfindungsgemäßen Kryostaten mit HTS-Sektion im Vakuum, mit einer gemeinsamen Bodenplatte für die Spulensektionen, in schematischer Darstellung;
- Fig. 2: eine dritte Ausführungsform eines erfindungsgemäßen Kryostaten mit HTS-Sektion im Vakuum, mit zwei Heliumtanks, in schematischer Darstellung;
- Fig. 3: die schematische Verschaltung der Sektionen von Fig. 1a;
- Fig. 4: die schematische Verschaltung der Sektionen von Fig. 2.

Die **Figur 1a** zeigt eine erste Ausführungsform eines erfindungsgemäßen Kryostaten 1. Der Kryostat 1 weist eine Raumtemperaturbohrung 2 auf, in der ein Messvolumen 3 für eine Probe vorgesehen ist. Das Messvolumen 3 befindet sich im Zentrum eines Magnetspulensystems, das hier von drei solenoidförmigen Spulensektionen 4, 5, 6 gebildet wird. Die radial innerste Spulensektion 4 ist mit einem Draht aus Hochtemperatursupraleiter(=HTS) gewickelt.
Die mittlere Spulensektion 5 ist mit Nb₃Sn-Draht gewickelt, und die äußerste Spulensektion 6 ist mit NbTi-Draht gewickelt. Die Spulensektionen 5, 6 stellen somit Tieftemperatursupraleiter(=LTS)-Spulensektionen dar. Die Spulensektionen 4, 5, 6 sind in Serie elektrisch miteinander verbunden, beispielhaft ist dies mit den beiden supraleitenden Übergangsstellen (Joints) 7a und 7b dargestellt. Am Joint 7a wird das HTS-Material einer Zuleitung 4a zur HTS-Spulensektion 4 mit einem Übergangsstück 8 aus NbTi verbunden, und am Joint 7b wird das Übergangsstück 8 mit dem Nb₃Sn-Draht der LTS-Sektion 5 verbunden. Das Übergangsstück 8 tritt an einer Durchführung 18 durch eine Wand 9a eines Heliumtanks 9, in dem sich ineinander geschachtelt die LTS-Sektionen 5 und 6 befinden. Die Durchführung 18 ist eine herkömmliche elektrische Tieftemperatur-Vakuumdurchführung mit gegeneinander und gegen die Tankwand isolierten metallischen Röhrchen, in die jeweils der Leiter des Übergangsstücks 8 vakuumdicht eingelötet ist. Die Wand 9a des Heliumtanks 9 ist der Raumtemperaturbohrung 2 zugewandt.

Der Heliumtank 9 ist weitgehend mit flüssigem Helium gefüllt. Das flüssige Helium im Heliumtank 9 hat eine Temperatur T_{L} von etwa 4 K. Der Heliumtank 9 ist zur Isolation vollständig, insbesondere radial außen von einem Strahlungsschild 10 umgeben. Der Strahlungsschild 10 verläuft auch zwischen der HTS-Sektion 4 und der Raumtemperaturbohrung 2. Der Strahlungsschild 10 wird mit flüssigem Stickstoff gekühlt, der in Behälter 10a eingefüllt werden kann. Zusätzlich können weitere Strahlungsschilde vorgesehen sein, die üblicherweise auch durch abdampfendes Heliumgas gekühlt werden. Alternativ oder zusätzlich können die Strahlungsschilde refrigeratorgekühlt werden, wodurch der Stickstofftank 10 entfallen kann. Der Refrigerator kann auch eine Rückkühlung des abdampfenden Heliums übernehmen, so dass die Nachfüllintervalle für flüssiges Helium verlängert werden oder Nachfüllen überhaupt nur noch nach einem Störfall nötig ist.

Während die LTS-Spulensektionen 5, 6 in das flüssige Helium eintauchen, ist die HTS-Spulensektion 4 samt der Zuleitung 4a und dem Joint 7a im Vakuum zwischen Heliumtank 9 und Raumtemperaturbohrung 2 angeordnet. Dadurch wird sichergestellt, dass kein flüssiges Helium in HTS-Material der HTS-Spulensektion 4 oder deren Zuleitung 4a eindringen kann. Infolgedessen kann es auch nicht dazu kommen, dass flüssiges Helium im Inneren des HTS-Materials verdampft und durch die Volumenzunahme das HTS-Material von Innen heraus aufsprengen kann.

Die Gesamtheit des evakuierten Innenraums des Kryostaten 1 bildet den Vakuumteil 14 des Kryostaten 1, und innerhalb dieses Vakuumteils 14 ist erfindungsgemäß die HTS-Sektion 4 angeordnet. Im Vakuumteil 14 herrscht ein Druck von weniger als 10⁻⁵ mbar.

Die HTS-Spulensektion 4 liegt vorzugsweise kraftschlüssig an der Innenwand 9a des Heliumtanks 9 an. Über die Tankwand 9a wird HTS-Sektion 4 gekühlt. Ggf. kann hier auch ein guter Wärmeleiter wie metallisches Kupfer eingesetzt werden. Die LTS-Sektion 5 kann kraftschlüssig, ggf. über Distanzstücke 11 mit der Heliumtankwand 9a verbunden sein. Ein kleiner Abstand zur Tankwand 9a erlaubt in einem Spalt 12 Heliumkonvektion noch radial innerhalb der Sektion 5. Alternativ schließt die Sektion 5 ebenfalls unmittelbar an die Wand 9a an. Es kann in der Regel toleriert werden, dass die HTS-Sektion 4 etwas wärmer ist als die LTS-Sektionen 5 und 6. Zwischen der HTS-Sektion 4 und der Raumtemperaturbohrung 2 befinden sich ein weiteres Strahlungsschild19, um Sektion 4 thermisch abzuschirmen. Der Strahlungsschild 19 wird über das flüssige Helium des Heliumtanks 9 gekühlt. Weitere Strahlungsschilde zur Abschirmung der HTS-Sektion 4 können hinzutreten.

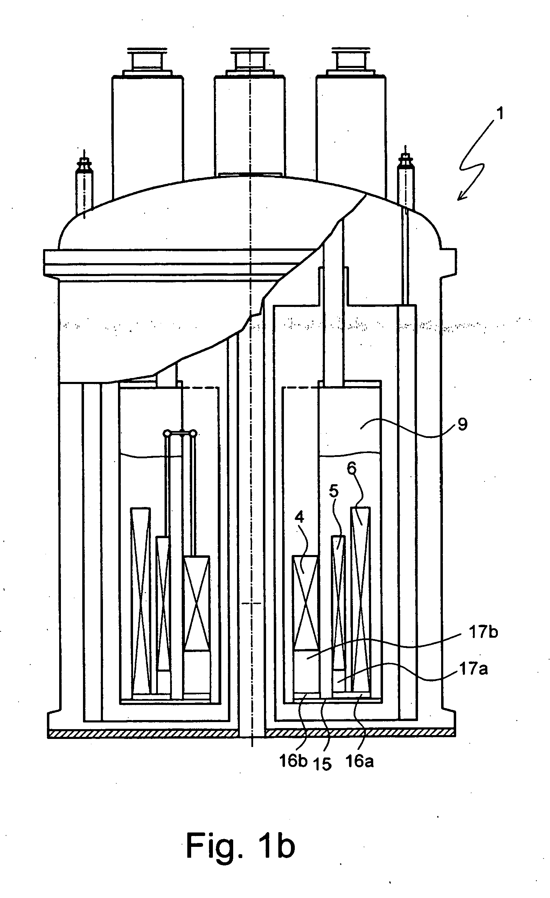

Eine zweite Ausführungsform eines erfindungsgemäßen Kryostaten 1 ist in **Figur 1b** dargestellt. Diese Ausführungsform entspricht weitgehend der Ausführungsform von Fig. 1a, jedoch ist eine besondere Verankerung der Spulensektionen 4, 5, 6 vorgesehen.

Eine Bodenplatte 15 bildet mit einem radial äußeren Teil die untere Wand des Heliumtanks 9. Die Bodenplatte 15 setzt sich radial nach innen bis unter die HTS-Sektion 4 fort. Auf der Bodenplatte 15 sind zwei Ringflansche 16a, 16b befestigt. Auf dem radial äußeren Ringflansch 16a ist die LTS-Sektion 6 direkt, und die LTS-Sektion 5 über einen Spulenträger 17a befestigt. Auf dem radial inneren Ringflansch 16b ist die HTS-Sektion 4 über einen Spulenträger 17b befestigt. Die Bodenplatte 15 ist bevorzugt einstückig ausgebildet. Die beschriebene Anordnung gestattet eine gleichzeitige Handhabung aller Spulensektionen 4, 5, 6 bei der Montage des Kryostaten 1 über die gemeinsame Bodenplatte 15.

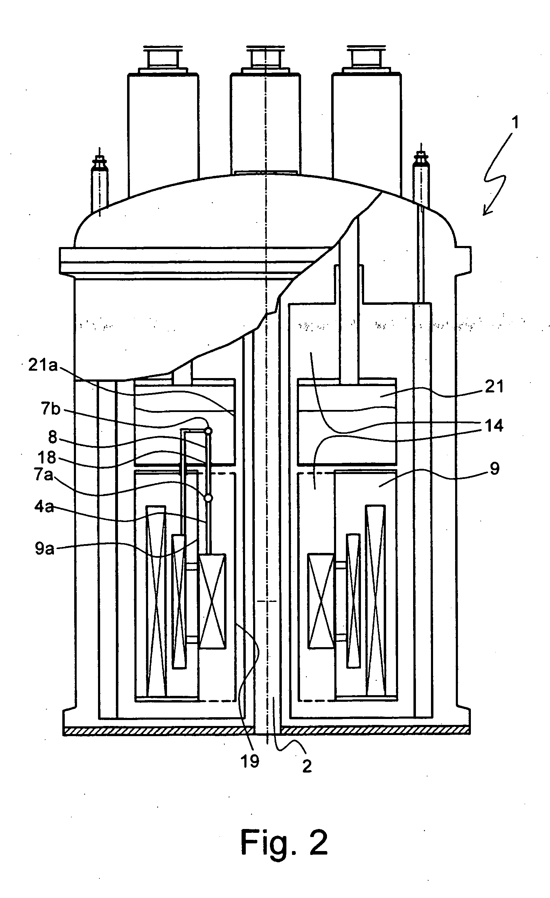

Die dritte Ausführungsform eines erfindungsgemäßen Kryostaten 1 von **Figur 2** entspricht weitgehend dem Kryostaten von Figur 1. Der Kryostat 1 von Figur 2 verfügt jedoch neben dem Heliumtank 9 auch noch über einen weiteren, darüber angeordneten Heliumtank 21. Beide Heliumtanks 9, 21 enthalten Helium auf unterschiedlicher Temperatur, in der Regel etwa 2 K beim unteren Heliumtank 9 und etwa 4 K beim oberen, weiteren Heliumtank 21. Kryostaten 1 von diesem Typ werden vorwiegend zur Erzeugung sehr hoher Magnetfeldstärken eingesetzt, insbesondere für Hochfeld-NMR-Systeme.

In der in Fig. 2 gezeigten Ausführungsform erstreckt sich der weitere Heliumtank 21 weiter nach innen (auf die Raumtemperaturbohrung 2 zu) als der untere Heliumtank 9, und eine Durchführung 18 für das Übergangsstück 8 ist im Boden des weiteren Heliumtanks 21 angeordnet. Die Innenwand 21a des weiteren Heliumtanks 21, die der Raumtemperaturbohrung 2 zugewandt ist, befindet sich in gleichem radialen Abstand von der Raumtemperaturbohrung 2 wie der Strahlungsschild 19; die Innenwand 9a des Heliumtanks 9 ist demgegenüber zurückgesetzt. Mit dieser Anordnung kann der Raum innerhalb des Kryostaten 1 effizient genutzt werden.

In einer alternativen, nicht dargestellten Ausführungsform kann die Innenwand des weiteren Heliumtanks auch zurückgesetzt sein, wobei sie in gleichem radialen Abstand zur Raumtemperaturbohrung 2 angeordnet, ist wie die Innenwand 9a des Heliumtanks 9 in Fig. 1b. Dies schafft Raum, um die Durchführung für das supraleitende Übergangsstück vom Vakuumteil in den oberen, weiteren Heliumtank horizontal durch die Innenwand des weiteren Heliumtanks zu führen. Bevorzugt ist die Durchführung dabei oberhalb des Spiegels von flüssigem Helium im weiteren Heliumtank angeordnet. Dies erleichtert die sichere Abdichtung der Durchführung.

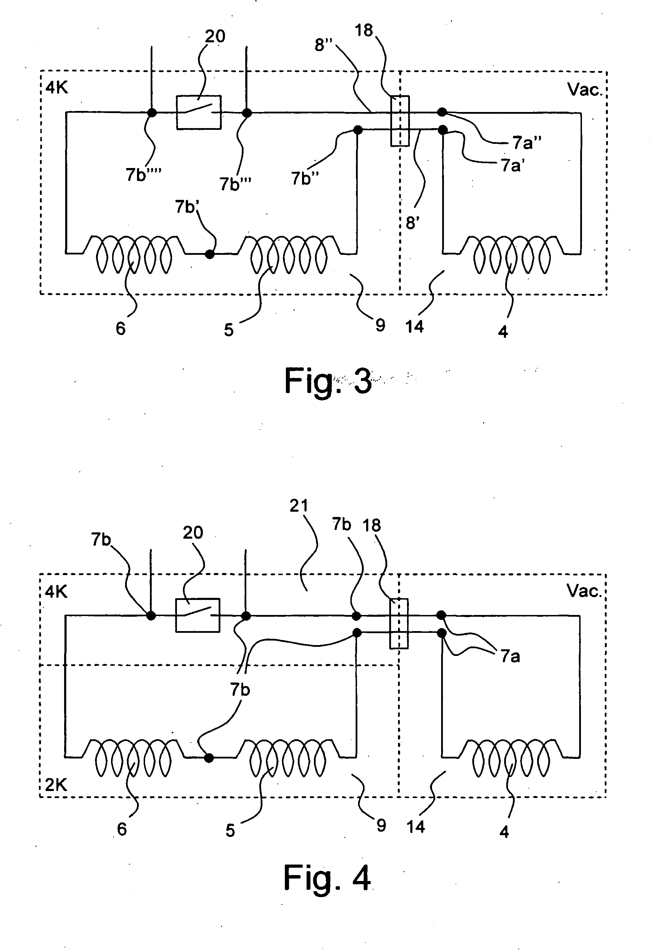

**Figur 3** zeigt schematisch die elektrische Verschaltung der Spulensektionen 4, 5, 6 aus Fig. 1a. Der Innenbereich des Heliumtanks 9 (Heliumbereich) ist als gestrichelter Block dargestellt, ebenso wie der Bereich des Vakuumteils 14 des Kryostaten (Vakuumbereich) als gestrichelter Block dargestellt ist.

Die LTS-Sektionen 6 (NbTi) und 5 (Nb3Sn) befinden sich bei etwa 4 K in flüssigem Helium innerhalb des Heliumbereichs 9. Die LTS-Sektionen 5, 6 sind über eine supraleitende Verbindung (7b'; joint) in Serie geschaltet. LTS-Sektion 5 ist über eine weitere supraleitende Verbindung 7b" mit einem Übergangsstück 8' verbunden, das durch die vakuumdichte Durchführung 18 aus dem Heliumbereich 9 in den Vakuumbereich 14 führt. Dort ist das Übergangsstück 8' über eine supraleitende Verbindung 7a' mit dem Leiter einer Seite der HTS-Sektion 4 verbunden, die sich im Vakuumbereich 14 befindet. Der HTS-Leiter der anderen Seite ist supraleitend mit einem Übergangsstück 8" im Joint 7a" verbunden. Das Übergangsstück 8" führt durch die vakuumdichte Durchführung 18 zurück in den Heliumbereich 9, wo es am Joint 7b"' mit einem Ende eines supraleitenden Kurzschlussschalters 20 für die gesamte Spulenanordnung 4, 5, 6 verbunden ist. Das andere Ende des Kurzschlussschalters 20 ist letztlich über Joint 7b'''' wieder mit der Sektion 6 verbunden.

Entsprechend verschaltet.sind die Sektionen 4, 5, 6 des Ausführungsbeispiels nach Fig. 2, was schematisch in **Figur 4** dargestellt ist. Allerdings gibt es hier zwei Heliumbereiche 9 und 21 auf unterschiedlichen Temperaturbereichen (etwa 2 K bzw. etwa 4 K), entsprechend dem Heliumtank 9 (auf 2 K) und dem weiteren Heliumtank 21 (auf 4 K). Weiterhin gibt es den Vakuumbereich 14, entsprechend dem Vakuumteil 14.

Die Durchführung 18 mündet vom Vakuumteil 14 in den 4K-Bereich 21, in dem auch der supraleitende Schalter 20 angeordnet ist. Die LTS-Sektionen 5, 6 befinden sich im 2K-Bereich 9. Abhängig von den topologischen Gegebenheiten und der Auslegung der Joints 7a, 7b, bzw. des Schalters 20 bezüglich ihrer Temperatur- und Feldverträglichkeiten können einige oder alle dieser Komponenten im 4K-Bereich 21 oder im 2K-Bereich 9 angeordnet sein. Es ist bevorzugt, die Durchführung 18 in den 4K-Bereich 21 münden zu lassen, wo es kein superflüssiges Helium gibt. Dies erhöht die Sicherheit.

Grundsätzlich kann die Durchführung 18 aber auch direkt in den 2K-Bereich führen, wenn Dichtigkeit gegen superflüssiges Helium sicher gewährleistet ist.

Die Kryostaten 1 der Figuren 1a, 1b und 2 sind bevorzugt Teile einer NMR-Apparatur, wie etwa eines NMR-Spektrometers oder eines NMR-Tomographen, insbesondere eines hochauflösenden Hochfeld-NMR-Spektrometers mit einem Magnetfeld B₀ > 20 T, vorzugsweise > 23 T im Messvolumen, wobei das Magnetspulensystem bezüglich der Homogenität des Magnetfelds B₀ im Messvolumen und der zeitlichen Stabilität von B₀ die Anforderungen der hochauflösenden NMR-Spektroskopie erfüllt, was in der Regel voraussetzt, dass die Spulensektionen des Magnetspulensystems im Betrieb supraleitend kurzgeschlossen werden können. In der Regel werden - wie in den gezeigten Ausführungsbeispielen - die Spulenachsen und die Raumtemperaturbohrung vertikal stehen. Die Erfindung bezieht sich aber auch auf Kryostaten mit horizontaler Bohrung, die vorzugsweise im bildgebenden Bereich (MRI) oder auch für lonenzyklotron-Resonanzspektrometer Verwendung finden.

## Patentansprüche

1. Kryostat (1), mit einem supraleitfähige Leiter umfassenden Magnetspulensystem zur Erzeugung eines Magnetfelds B₀ in einem Messvolumen (3) in einer Raumtemperaturbohrung (2) des Kryostaten (1), mit mehreren, radial ineinander geschachtelt angeordneten, die Raumtemperaturbohrung umgebenden, elektrisch in Serie geschalteten, solenoidförmigen Spulensektionen (4, 5, 6), von denen mindesten eine LTS-Sektion (5, 6) einen konventionellen Tieftemperatursupraleiter (LTS) und mindestens eine HTS-Sektion (4) einen Hochtemperatursupraleiter (HTS) umfasst,
wobei sich die LTS-Sektion (5,6) mit flüssigem Helium in einem Heliumtank (9) des Kryostaten (1) bei einer Heliom-Temperatur T_{L} befindet,
**dadurch gekennzeichnet,**
**dass** die HTS-Sektion (4) radial innerhalb der LTS-Sektion (5, 6) in einem Vakuumteil (14) des Kryostaten (1) angeordnet ist und von der LTS-Sektion (5, 6) durch die der Raumtemperaturbohrung (2) zugewandte Wand (9a) des Heliumtanks (9) getrennt ist.

2. Kryostat (1) nach Anspruch 1, **dadurch gekennzeichnet, dass** die Temperatur des flüssigen Heliums T_{L} < 4 K, vorzugsweise < 2,5 K, insbesondere < 2,2 K ist.

3. Kryostat (1) nach Anspruch 1, **dadurch gekennzeichnet, dass** auch supraleitende Zuleitungen (4a) zur mindestens einen HTS-Sektion (4) im Vakuumteil (14) verlaufen, und zwar mindestens soweit die Zuleitungen (4a) HTS enthalten.

4. Kryostat (1) nach einem der vorhergehenden Ansprüche, **dadurch gekennzeichnet, dass** der Vakuumteil (14) eine Druckmesseinrichtung aufweist.

5. Kryostat (1) nach einem der vorhergehenden Ansprüche, **dadurch gekennzeichnet, dass** die LTS-Sektion (5, 6) mit der HTS-Sektion (4) mechanisch starr verbunden ist, insbesondere durch die Wand (9a) des Heliumtanks (9).

6. Kryostat (1) nach einem der vorhergehenden Ansprüche, **dadurch gekennzeichnet, dass** die HTS-Sektion (4) thermisch an die Wand (9a) des Heliumtanks (9) angekoppelt ist.

7. Kryostat (1) nach einem der vorhergehenden Ansprüche, **dadurch gekennzeichnet, dass** sich zwischen HTS-Sektion (4) und Raumtemperaturbohrung (2) mindestens ein Strahlungsschild (10, 19) befindet.

8. Kryostat (1) nach einem der vorhergehenden Ansprüche, **dadurch gekennzeichnet, dass** im Vakuumteil (14) Sorptionsmittel für Helium angeordnet sind, insbesondere Aktivkohle.

9. Kryostat (1) nach einem der vorhergehenden Ansprüche, **dadurch gekennzeichnet, dass** das im Messvolumen (3) durch das Magnetspulensystem erzeugte Magnetfeld B₀ größer als 20 T, insbesondere größer als 23 T ist.

10. Kryostat (1) nach einem der vorhergehenden Ansprüche, **dadurch gekennzeichnet, dass** die Spulensektionen (4, 5, 6) des Magnetspulensystems im Betrieb supraleitend kurzgeschlossen werden können.

11. Kryostat (1) nach Anspruch 10, **dadurch gekennzeichnet, dass** das Magnetspulensystem bezüglich der Homogenität des Magnetfelds B₀ im Messvolumen (3) und der zeitlichen Stabilität von B₀ die Anforderungen der hochauflösenden NMR-Spektroskopie erfüllt.

12. Kryostat (1) nach einem der Ansprüche 2 bis 11, **dadurch gekennzeichnet, dass** er einen weiteren Heliumtank (21) mit einer Temperatur des darin enthaltenen flüssigen Heliums von etwa 4,2 K aufweist.

13. Kryostat (1) nach Anspruch 12, **dadurch gekennzeichnet, dass** die Serienschaltung zwischen der LTS-Sektion (5, 6) im Heliumtank (9) und der HTS-Sektion (4) im Vakuumteil (14) über den weiteren Heliumtank (21) verläuft.

14. Kryostat (1) nach Anspruch 12 oder 13, **dadurch gekennzeichnet, dass** der weitere Heliumtank (21) über dem Heliumtank (9) um eine gemeinsame, vertikale Raumtemperaturbohrung (2) angeordnet ist.

15. Kryostat (1) nach Anspruch 14, **dadurch gekennzeichnet, dass** die der Raumtemperaturbohrung (2) zugewandte Wand (21a) des weiteren Heliumtanks (21) radial von der Raumtemperaturbohrung (2) gleich weit beabstandet ist wie die der Raumtemperaturbohrung (2) zugewandte Wand (9a) des Heliumtanks (9).

## Claims

1. Cryostat (1), having a magnet coil system comprising superconductors for production of a magnet field B₀ in a measurement volume (3) within a room temperature bore (2) of the cryostat (1), with a plurality of radially nested solenoid-shaped coil sections (4, 5, 6) which surround the room temperature bore and which are electrically connected in series, at least one section of which being an LTS section (5, 6) of a conventional low temperature (LTS) superconductor and with at least one HTS section (4) having a high temperature superconductor (HTS), wherein the LTS section (5, 6) is disposed with liquid helium in a helium tank (9) of the cryostat (1) at a helium temperature T_{L},
**characterized in that**
the HTS section (4) is disposed radially within the LTS section (5, 6) in a vacuum portion (14) of the cryostat (1) and is separated from the LTS section (5, 6) by a wall (9a) of the helium tank (9) facing the room temperature bore (2).

2. Cryostat (1) according to claim 1, **characterized in that** the temperature of the liquid helium T_{L} is less than 4 K, preferentially less than 2.5 K, in particular less than 2.2 K.

3. Cryostat (1) according to claim 1, **characterized in that** superconducting leads (4a) to at least one HTS section (4) also extend through the vacuum portion (14) at least to the extent that the leads (4a) contain HTS.

4. Cryostat (1) according to any one of the preceding claims, **characterized in that** the vacuum portion (14) has a pressure-measuring device.

5. Cryostat (1) according to one or more of the preceding claims, **characterized in that** the LTS section (5, 6) is mechanically rigidly connected to the HTS section (4), in particular, via the wall (9a) of the helium tank (9).

6. Cryostat (1) according to any one of the preceding claims, **characterized in that** the HTS section (4) is thermally coupled to the wall (9a) of the helium tank (9).

7. Cryostat (1) according to one or more of the preceding claims, **characterized in that** at least one radiation shield (10, 19) is disposed between the HTS section (4) and the room temperature bore (2).

8. Cryostat (1) according to any one of the preceding claims, **characterized in that** in the vacuum portion (14) a sorption medium for helium is disposed, in particular activated charcoal.

9. Cryostat (1) according to one or more of the preceding claims, **characterized in that** the magnet coil system produces a magnetic field (B₀) in the measurement volume (3), which is larger than 20 T, in particular larger than 23 T.

10. Cryostat (1) according to any one of the preceding claims, **characterized in that** the coil sections (4, 5, 6) of the magnet coil system may be superconductingly short-circuited during operation.

11. Cryostat (1) according to claim 10, **characterized in that** the magnet coil system fulfills the requirements of high resolution NMR spectroscopy with regard to the homogeneity of the magnetic field B₀ in the measurement volume (3) as well as the temporal stability of B₀.

12. Cryostat (1) according to any one of the claims 2 through 11, **characterized in that** it includes an additional helium tank (21) having liquid helium contained therein at a temperature of approximately 4.2 K.

13. Cryostat (1) according to claim 12, **characterized in that** the series connection between the LTS section (5, 6) in the helium tank (9) and the HTS section (4) in the vacuum portion (14) passes through the additional helium tank (21).

14. Cryostat (1) according to claim 12 or 13, **characterized in that** the additional helium tank (21) is disposed above the helium tank (9) about a common, vertically orientated room temperature bore (2).

15. Cryostat (1) of claim 14, **characterized in that** the wall (21a) of the additional helium tank (21) facing the room temperature bore (2) is radially equally distant from the room temperature bore (2) as the wall (9a) of the helium tank (9) facing the room temperature bore (2).

## Revendications

1. Cryostat (1), avec un système de bobines magnétiques comprenant des conducteurs supraconducteurs pour générer un champ magnétique B₀ dans un volume de mesure (3) dans un alésage à température ambiante (2) du cryostat (1), avec plusieurs sections de bobine (4, 5, 6) en forme de solénoïdes emboîtées les unes dans les autres radialement, entourant l'alésage à température ambiante et couplées en série électriquement, dont au moins une section LTS (5, 6) comprend un supraconducteur à basse température (LTS) conventionnel et au moins une section HTS (4) un supraconducteur à haute température (HTS), les sections LTS (5, 6) se trouvant avec de l'hélium liquide dans un réservoir d'hélium (9) du cryostat (1) à une température d'hélium T_{L},
**caractérisé en ce**
**que** la section HTS (4) est disposée radialement à l'intérieur de la section LTS (5, 6) dans une partie sous vide (14) du cryostat (1) et séparée de la section LTS (5, 6) par la paroi (9a) du réservoir d'hélium (9) tournée vers l'alésage à température ambiante (2).

2. Cryostat (1) selon la revendication 1, **caractérisé en ce que** la température de l'hélium liquide T_{L} est < 4 K, de préférence < 2,5 K, en particulier < 2,2 K.

3. Cryostat (1) selon la revendication 1, **caractérisé en ce que** des lignes d'amenée supraconductrices (4a) vers au moins une section HTS (4) passent aussi dans la partie sous vide (14), au moins au point que les lignes d'amenée (4a) contiennent du matériau HTS.

4. Cryostat (1) selon l'une des revendications précédentes, **caractérisé en ce que** la partie sous vide (14) présente un dispositif de mesure de pression.

5. Cryostat (1) selon l'une des revendications précédentes, **caractérisé en ce que** la section LTS (5, 6) est reliée de façon mécaniquement rigide à la section HTS (4), en particulier par la paroi (9a) du réservoir d'hélium (9).

6. Cryostat (1) selon l'une des revendications précédentes, **caractérisé en ce que** la section HTS (4) est couplée thermiquement à la paroi (9a) du réservoir d'hélium (9).

7. Cryostat (1) selon l'une des revendications précédentes, **caractérisé en ce qu'**au moins un écran anti-radiation (10, 19) se trouve entre la section HTS (4) et l'alésage à température ambiante (2).

8. Cryostat (1) selon l'une des revendications précédentes, **caractérisé en ce que** des agents de sorption de l'hélium, en particulier du charbon actif, sont disposés dans la partie sous vide (14).

9. Cryostat (1) selon l'une des revendications précédentes, **caractérisé en ce que** le champ magnétique B₀ généré par le système de bobines magnétiques dans le volume de mesure (3) est supérieur à 20 T, en particulier supérieur à 23 T.

10. Cryostat (1) selon l'une des revendications précédentes, **caractérisé en ce que** les sections de bobine (4, 5, 6) du système de bobines magnétique peuvent être court-circuitées de manière supraconductrice en fonctionnement.

11. Cryostat (1) selon la revendication 10, **caractérisé en ce que** le système de bobines magnétiques satisfait les exigences d'homogénéité du champ magnétique B₀ dans le volume de mesure (3) et de stabilité dans le temps de B₀ de la spectroscopie RMN à haute résolution.

12. Cryostat (1) selon l'une des revendications 2 à 11, **caractérisé en ce qu'**il présente un réservoir d'hélium supplémentaire (21) avec une température de l'hélium liquide qu'il contient d'environ 4,2 K.

13. Cryostat (1) selon la revendication 12, **caractérisé en ce que** le couplage en série entre la section LTS (5, 6) dans le réservoir d'hélium (9) et la section HTS (4) dans la partie sous vide (14) passe par le réservoir d'hélium supplémentaire (21).

14. Cryostat (1) selon la revendication 12 ou 13, **caractérisé en ce que** le réservoir d'hélium supplémentaire (21) est disposé au-dessus du réservoir d'hélium (9) autour d'un alésage à température ambiante (2) vertical commun.

15. Cryostat (1) selon la revendication 14, **caractérisé en ce que** la paroi (21a) du réservoir d'hélium supplémentaire (21) tournée vers l'alésage à température ambiante (2) est située à la même distance radiale de l'alésage à température ambiante (2) que la paroi (9a) du réservoir d'hélium (9) tournée vers l'alésage à température ambiante (2).
